**Europäisches Patentamt**

**European Patent Office**

**Office européen des brevets**

(19)

(11) Veröffentlichungsnummer : **0 043 085**
**B1**

(12) # EUROPÄISCHE PATENTSCHRIFT

(45) Veröffentlichungstag der Patentschrift :
26.09.84

(21) Anmeldenummer : 81104847.9

(22) Anmeldetag : 23.06.81

(51) Int. Cl.³ : **G 03 G   5/05**, G 03 G   5/14,
**G 03 G  13/26**

(54) Verfahren zur Herstellung von Druckformen oder gedruckten Schaltungen.

(30) Priorität : 30.06.80 DE 3024718

(43) Veröffentlichungstag der Anmeldung :
06.01.82 Patentblatt 82/01

(45) Bekanntmachung des Hinweises auf die Patenterteilung : 26.09.84 Patentblatt 84/39

(84) Benannte Vertragsstaaten :
AT BE CH DE FR GB IT LI NL SE

(56) Entgegenhaltungen :
DE-A- 1 810 079
DE-A- 2 322 047
R.M. Schaffert "Electrophotography", 4. Ausgabe
1975, Focal Press LONDON (GB), Abschnitt 17.5.3
"Photoengraving", Seiten 627-628
80401546

(73) Patentinhaber : HOECHST AKTIENGESELLSCHAFT
Postfach 80 03 20
D-6230 Frankfurt am Main 80 (DE)

(72) Erfinder : Lind, Erwin, Dr.
Holunderweg 7
D-6200 Wiesbaden (DE)

EP 0 043 085 B1

## Beschreibung

Die Erfindung betrifft ein Verfahren zur Herstellung von Druckformen oder gedruckten Schaltungen durch Beschichtung eines elektrisch leitenden Trägers mit einer organischen Photoleiterschicht und durch Aufladen, Belichten, Entwickeln des elektrostatischen Bildes mit einem feinteiligen Toner, Fixieren und Weglösen der Schicht an den bildfreien Stellen mit einem Entschichter sowie gegebenenfalls Ätzen der freigelegten Trägeroberfläche.

In der Regel sind die für elektrophotographische Zwecke zu verwendenden, mit einem Photoleiter zu beschichtenden Materialien elektrisch leitfähig und bestehen aus Metallen wie Aluminium, Kupfer, Zink oder Magnesium oder sie bestehen oberflächlich aus Metallverbindungen wie Aluminiumoxid, Zinnoxid, Indiumoxid oder Kupferjodid oder sind oberflächlich mit einem Antistatikum behandelt. Die zu beschichtenden Materialien liegen in der Praxis vorwiegend in Form von Platten oder Folien vor. Bisher war es üblich, diese Materialien durch eine Lackierung mit einer elektrophotographischen Schicht zu versehen, wobei der organische Photoleiter gegebenenfalls zusammen mit Bindemitteln und weiteren Zusätzen zur Herstellung eines Lackes in organischen Lösungsmitteln gelöst werden mußte, wie dies aus DE-A-23 22 046 bzw. 23 22 047 für die Herstellung von Druckformen oder metalischen Ätzbildern bekannt ist. Die Lösung wurde maschinell aufgetragen, und das Lösungsmittel durch Temperatureinwirkung anschließend verdampft. Sofern man die Beschichtung in großtechnischem Maßstab durchführen konnte, war die Beseitigung der anfallenden Lösungsmitteldämpfe kein technisches Problem, und sie stellt keinen ins Gewicht fallenden Kostenfaktor dar. So werden beispielsweise elektrophotographische Druckplatten mit Aluminium als Trägermaterial in hoher Qualität und umweltfreundlicher Verfahrensweise fabrikmäßig hergestellt. Andererseits will der Verarbeiter elektrophotographischer Materialien die Beschichtung aus Gründen des vorgegebenen Verfahrensablaufes oder auch aus Kostengründen selbst vornehmen. In diesen Fällen werden elektrophotographische Materialien in einer Menge benötigt, die eine fabrikmäßige Beschichtung mit einer aufwendigen Lösungsmittelwiedergewinnung oder -beseitigung nicht rechtfertigen.

Es ist ein Verfahren zur Herstellung eines elektrophotographischen Aufzeichnungsmaterials bekannt (DE-A 18 10 079), das eine erweichbare Schicht besitzt, in der sich dispergierte Teilchen befinden, welche im erweichten Zustand der Schicht unter Einfluß elektrischer Ladungen durch die Schicht wandern, bei dem ein schichtförmiger Teilchenspender mit einer Schicht der Teilchen gleichmäßig an die Oberfläche einer sich auf einem Schichtträger befindlichen, erweichbaren Schicht angedrückt wird, und Teilchenspender und erweichbare Schicht in übereinstimmender Geschwindigkeit zwischen Andruckrollen hindurchgeführt werden und bei dem anschließend Teilchenspender und erweichbare Schicht voneinander getrennt werden. Man kann hierbei mindestens eine der Andruckrollen auf Temperaturen zwischen 50 und 200 °C erhitzen.

Ein solches Verfahren ist zur Herstellung einer elektrophotographischen Druckform nicht geeignet, weil dort homogene Schichten gefordert sind, die nach Bebilderung und Fixierung oberflächlich durch Entschichten in hydrophile Nichtbildbereiche und oleophile Bildbereiche differenziert werden müssen. Außerdem erfordert das Dispergieren der anzudrückenden Teilchen erheblichen Aufwand und Energie. Schließlich ist auch der Teilchenspender mit der nur mit Dispergiermittel aufgebrachten Teilchenschicht nur kurzzeitig handhabbar und ist für eine weitere Lagerung nicht geeignet. Auch ein Aufwickeln ist nicht möglich, da sich die Teilchen dann auch über die Rückseite des Teilchenspenders verteilen.

Es war deshalb Aufgabe der Erfindung zur Herstellung von Druckformen oder gedruckten Schaltungen auf elektrophotographischem Wege ein Verfahren zur schaffen, das es ermöglicht, die Beschichtung auf einfache, umweltfreundliche Art und Weise ohne die Anwendung von Lösungsmittel möglichst unmittelbar vor der Weiterverarbeitung des Materials vorzunehmen.

Die Lösung dieser Aufgabe geht aus von einem Verfahren der im Oberbegriff des Anspruchs 1 genannten Art und ist dadurch gekennzeichnet, daß man zur Beschichtung die auf einem Zwischenträger angeordnete organische Photoleiterschicht mit Hilfe von Wärme und Druck auf den elektrischleitenden Träger überträgt. In bevorzugter Ausführungsform verwendet man als Zwischenträger eine Kunststoffolie wie eine aus Polyester, z. B. aus Polyethylenterephthalat, und überträgt die Photoleiterschicht bei Übertragungstemperaturen im Bereich von 100 bis 180 °C unter einem Druck von 2 bis 10 bar.

Ein Übertragungsverfahren der genannten Art ist aus DE-B-15 22 515 zur Herstellung photographischer reliefartiger Aufzeichnungen bekannt, wobei photopolymerisierbares Material in Form einer lichtempfindlichen Schicht von einem temporären auf einen permanenten Schichtträger übertragen wird. Bei diesem Verfahren zeigte es sich, daß die photochemischen Eigenschaften der lichtempfindlichen Substanzen durch den Übertragungsprozeß nicht beeinträchtigt werden. Hieraus was aber nicht abzuleiten, daß bei einem photophysikalischen Prozeß, wie dem elektrophotographischen Verfahren zur Herstellung von Druckformen oder gedruckten Schaltungen, die Übertragung ebenso ohne Beeinträchtigung der elektrophotographischen Eigenschaften durchführbar ist. Bei der Herstellung der genannten Druckformen spielt außer der Lichtempfindlichkeit eine geringe Dunkelentladung der aufgeladenen Photoleiterschicht eine außerordentlich wichtige Rolle, da von der Aufladung bis zur Entwicklung des gebildeten latenten Ladungsbildes eine gewisse Zeit von etwa einer halben bis zu einigen Minuten verstreicht. Bei zu großer Dunkelentladung würde bis zur Betonerung eine so starke Schwächung des Ladungsbildes erfolgen, daß keine, für die spätere Entschichtung unbedingt erforderliche, einwandfreie Tonerabdeckung mehr erfolgt. Durch eine thermische Beanspruchung einer Photoleiterschicht bei der Übertragung war weiter zu befürchten, daß irreversibel Ladungsträger erzeugt werden, die eine zu große Dunkelentladung der Photoleiterschicht bewirken. Bezüglich der Lichtempfindlichkeit der Photoleiterschicht bestanden Bedenken, daß durch die Temperatureinwirkung bei dem Übertragungsverfahren die verwendeten Aktivatoren bzw. Sensibilisatoren in Mitleidenschaft gezogen werden, so daß eine geringere Lichtempfindlichkeit resultierte.

Es wurde überraschend gefunden, daß man eine organische lösungsmittelfreie Photoleiterschicht durch Wärmeeinwirkung und unter Druck von einem Zwischenträger auf einen elektrisch leitenden Träger übertragen kann, ohne daß dabei die elektrophotographischen Eigenschaften, wie Aufladbarkeit, Dunkelentladung und Empfindlichkeit oder sonstige physikalische Eigenschaften, wie die Löslichkeit, verändert werden. Darin wurde eine Möglichkeit erkannt, elektrophotographische Schichten ohne die Mitwirkung organischer Lösungsmittel am Ort der Weiterverarbeitung z. B. in Reproanstalten oder Druckereien, auf die zur Weiterverarbeitung bestimmten Materialien aufzubringen. Das Problem einer Lösungsmittelbeseitigung oder einer Umweltbelastung durch Lösungsmitteldämpfe tritt dabei nicht auf. Die für die Durchführung des Verfahrens erforderlichen organischen Photoleiterschichten zusammen mit dem Zwischenträger können in bisher üblichen Verfahren fabrikmäßig in großem Maßstab hergestellt werden, wobei die dabei anfallenden Lösungsmittel rationell und quantitativ wiedergewonnen werden können.

Bei der Durchführung des erfindungsgemäßen Verfahrens bringt man zunächst an sich bekannte elektrophotographische Schichten durch Lackierung maschinell in definierter Dicke und hervorragender Gleichmäßigkeit auf ein geeignetes Folienmaterial als Zwischenträger auf. Am Ort der Verarbeitung können die Schichten dann mit Hilfe von Wärme und Druck ohne Qualitätsverlust von der Folie auf das zu verarbeitende Material übertragen werden.

Als geeignetes Zwischenträgermaterial haben sich Kunststoffolien vorzugsweise Polyesterfolien wie solche aus Polyethylenterephthalat als geeignet erwiesen, die oberflächlich vorbehandelt sein können, z. B. mit handelsüblichen Trennmitteln auf Silikonbasis.

Da das erfindungsgemäße Verfahren vorwiegend zur Herstellung von elektrophotographischen Druckformen oder gedruckten Schaltungen Anwendung findet, kann die Übertragung der Photoleiterschicht in einer Vorrichtung vorgenommen werden, die im einfachsten Falle aus einem geheizten Walzenpaar besteht. Die für die Übertragung der Photoleiterschicht erforderlichen Walzentemperaturen richten sich naturgemäß nach den thermoplastischen Eigenschaften der zu übertragenden Photoleiterschicht. Sie liegen in der Regel zwischen 100° und 180 °C. Bei der Übertragung ist es von Vorteil, zusätzlich zur Erwärmung Druck von einigen bar anzuwenden. Darüberhinaus hat man die Möglichkeit, dur Einstellung einer bestimmten Durchlaufgeschwindigkeit durch das Walzenpaar die Bedingungen für eine einwandfreie Übertragung der Photoleiterschicht festzulegen. In die Übertragungsbedingungen gehen die Hafteigenschaften und, wegen der Erwärmung, die Dicke des Materials mit ein, auf das die organische Photoleiterschicht übertragen werden soll.

Die folgenden Beispiele sollen die Durchführung und die Anwendung des Verfahrens näher erläutern.

Beispiel 1

Eine Lösung von 20 g 2,5-Bis-(4'-diethylaminophenyl)-1,3,4-oxadiazol, 20 g eines Mischpolymerisats aus Styrol und Maleinsäureanhydrid und 0,05 g Rhodamin B extra in 200 ml Glykolmonomethylether und 50 ml Butylacetat wird maschinell auf eine 100 μm dicke Polyesterfolie so aufgetragen, daß nach dem Verdunsten des Lösungsmittels eine etwa 5 μm dicke Schicht entsteht. Die hergestellte elektrophotographische Schicht wird zur Erstellung einer gedruckten Schaltung eingesetzt. Dazu verfährt man folgendermaßen :

Die zu bebildernde Kupferoberfläche einer Leiterplatte, die eine kupferlaminierte Kunststoffplatte darstellt, wird mit der beschichteten Polyesterfolie so abgedeckt, daß die Schichtseite auf das Kupfer zu liegen kommt. Das Gesamtmaterial wird dann mit einer Geschwindigkeit von 0,5 m/min durch ein auf 170 °C erwärmtes Walzenpaar aus einer elektrisch geheizten Metallwalze und einer mit Polytetrafluorethylen beschichteten Gegenwalze geschickt, wobei der Druck zwischen beiden Walzen etwa 10 bar beträgt. Nach dem Verlassen des Walzenpaares wird die Polyesterfolie von der Leiterplatte abgezogen. Die Photoleiterschicht haftet fest auf der Kupferoberfläche.

Nach dem Aufladen der Photoleiterschicht im Dunkeln mit Hilfe einer Corona auf ein Oberflächenpotential von − 400 V wird ein Bild in Form der Leiterbahn aufbelichtet. Bei Belichtung im Kontakt beträgt die Belichtungszeit bei Verwendung einer 100 W-Glühbirne im Abstand von 65 cm 10 Sekunden. Entwickelt wird das entstandene latente Ladungsbild mit einem flüssigentwickler, wie er in der französischen Patentschrift Nr. 74 14841 beschrieben ist. Dazu dispergiert man 1,5 g eines Hochvakuumbitumens mit einem Erweichungspunkt von 130-140 °C in einer Lösung von 6,5 g eines Pentaerythritharzesters in 1 000 ml eines Isoparaffins mit einem Siedebereich zwischen 185° und 210 °C. Die Entwicklung wird in der Photoschale vorgenommen. Nach der Entwicklung läßt man die überschüssige Entwicklerflüssigkeit ablaufen und verdunsten.

Danach wird die Photoleiterschicht an den nicht mit Toner abedeckten Stellen durch Weglösen entfernt, indem man das Material für 60 Sekunden in eine Lösung von 50 g $Na_2SiO_3 \cdot 9 H_2O$ in 250 g Glycerin (86 %ig), 390 g Ethylenglykol und 310 g Methanol eintaucht. Die angelöste Photoleiterschicht wird mit einem kräftigen Wasserstrahl abgespült, und restliche Nichtbildstellen werden gegebenenfalls mit einem Tampon ausgerieben.

Zur Herstellung einer gedruckten Schaltung wird die nun freiliegende Kupferschicht der Leiterplatte anschließend mit einem handelsüblichen Ätzmittel entfernt. Zurück bleibt eine mit Toner und Photoleiterschicht abgedeckte Leiterbahn aus Kupfer. Durch eine Nachbehandlung mit einem organischen Lösungsmittel kann die Leiterbahn leicht freigelegt werden.

Beispiel 2

Man löst 30 g eines Kondensationsproduktes aus 3-Brompyren und Formaldehyd, 15 g eines Terpolymeren aus 60 % n-Hexylmethacrylat, 10 % Styrol und 30 % Methacrylsäure mit einer Säurezahl von 180 und 1,6 g 9-Dicyanomethylen-2,7-dinitrofluoren in 300 ml Tetrahydrofuran. Mit der Lösung beschichtet man eine mit einem Silicontrennmittel vorbehandelte Polyesterfolie derart, daß nach dem Verdunsten des Tetrahydrofurans eine Schicht von 5 μm Dicke zurückbleibt. Das entstandene Folienmaterial enthält eine elektrophotographische Schicht, die durch Wärmeeinwirkung und unter Druck auf einen zu beschichtenden Druckplattenträger übertragen werden kann.

Dazu geht man wie folgt vor. Eine mechanisch oberflächlich aufgerauhte Aluminiumfolie wird mit der beschichteten Polyesterfolie so abgedeckt, daß die Photoleiterschicht auf die aufgerauhte Aluminiumoberfläche zu liegen kommt. Man verfährt dann so, wie es in Beispiel 1 beschrieben ist und gibt das Material durch ein auf 150 °C geheiztes Walzenpaar, wobei ein Walzendruck von 6 bar ausreichend ist. Nach dem Entfernen der Polyesterfolie entsteht eine elektrophotographische Flachdruckform mit einer das Kondensationsprodukt aus 3-Brompyren und Formaldehyd als Photoleiter enthaltenden Schicht.

Die Bebilderung der Platte und die Umwandlung in eine Druckform erfolgt in bekannter Weise durch Aufladen, Belichten, Betonern, Fixieren und Entfernen der Photoleiterschicht an den bildfreien Stellen durch Weglösen, wobei die in Beispiel 1 beschriebene Lösung verwendet wird.

Beispiel 3

Auf eine aluminiumbedampfte 75 μm dicke Polyesterfolie bringt man eine Lösung von 16 g 2-Vinyl-4-(2'-chlorphenyl)-5(4''-diethylaminophenyl)-oxazol, 24 g eines Mischpolymerisats aus Styrol und Maleinsäureanhydrid und 0,4 g Astrazonorange R (C.I. 48 040) in 120 ml Glykolmonomethylether, 190 ml Tetrahydrofuran und 50 ml Butylacetat so auf, daß nach dem Verdunsten der Lösungsmittel eine 5 μm dicke Schicht zurückbleibt. Die erhaltene Folie stellt ein leicht zu handhabendes Beschichtungsmaterial zum Beschichten von Druckplattenträgermaterialien dar.

Man stellt damit eine elektrophotographische Druckplatte her, indem man die Schichtseite der Folie auf eine elektrochemisch aufgerauhte, anodisierte und mit polyvinylphosphonsäure vorbehandelte Aluminiumplatte legt und durch ein auf 170 °C erhitztes Walzenpaar bei einem Druck von 6 bar laufen läßt, wie es in Beispiel 1 bereits beschrieben ist. Nach dem Abkühlen zieht man die aluminiumbedampfte Polyesterfolie ab.

Die Platte wird im Dunkeln mit Hilfe einer Corona auf − 400 V aufgeladen und mit Hilfe eines modulierten 10 mW Argonionenlasers bildmäßig belichtet. Die Entwicklung des latenten Bildes mit einem Trockentoner, das Fixieren und die Umwandlung in eine Druckform durch Weglösen der Photoleiterschicht an den bildfreien Stellen erfolgt in bekannter Weise. Man erhält eine Druckform mit hoher Auflagenstabilität, die im Zeitungsdruck eingesetzt werden kann.

**Ansprüche**

1. Verfahren zur Herstellung von Druckformen und gedruckten Schaltungen durch Beschichtung eines elektrisch leitenden Trägers mit einer organischen Photoleiterschicht, und durch Aufladen, Belichten, Entwickeln des elektrostatischen Bildes mit einem feinteiligen Toner, Fixieren und Weglösen der Schicht an den bildfreien Stellen mit einem Entschichter sowie gegebenenfalls Ätzen der freigelegten Trägeroberfläche, dadurch gekennzeichnet, daß man zur Beschichtung die auf einem Zwischenträger angeordnete organische Photoleiterschicht aus Photoleiter, Bindemittel und Zusätzen mit Hilfe von Wärme und Druck auf den elektrisch leitenden Träger überträgt.

2. Verfahren nach Anspruch 1, dadurch gekennzeichnet, daß man als Zwischenträger eine Kunststoffolie verwendet.

3. Verfahren nach Anspruch 2, dadurch gekennzeichnet, daß man eine Kunststoffolie aus Polyester verwendet.

4. Verfahren nach Ansprüchen 1 bis 3, dadurch gekennzeichnet, daß man die organische Photoleiterschicht bei Übertragungstemperaturen im Bereich von 100 bis 180 °C überträgt.

5. Verfahren nach Ansprüchen 1 bis 4, dadurch gekennzeichnet, daß man die organische Photoleiterschicht unter einem Druck von 2 bis 10 bar überträgt.

6. Verfahren nach Ansprüchen 1 bis 5, dadurch gekennzeichnet, daß der elektrisch leitende Träger eine Metallplatte oder -folie ist.

7. Verfahren nach Anspruch 6, dadurch gekennzeichnet, daß der elektrisch leitende Träger eine kupferlaminierte Kunststoffplatte ist.

8. Verfahren nach Anspruch 6, dadurch gekennzeichnet, daß der elektrisch leitende Träger eine mechanisch oberflächlich aufgerauhte Aluminiumfolie ist.

9. Verfahren nach Anspruch 6, dadurch gekennzeichnet, daß der elektrisch leitende Träger eine elektrochemisch aufgerauhte, anodisierte und mit Polyvinylphosphonsäure oder mit Silikat vorbehandelte Aluminiumplatte ist.

## Claims

1. A process for the manufacture of printing forms and printed circuits by coating an electrically conductive support with an organic photoconductor layer and by charging, exposing, developing the electrostatic image by means of a finely particulate toner, fixing and dissolving the layer away from the non-image areas by means of a decoating agent and, if appropriate, etching the bared support surface, wherein, for the purpose of coating, the organic photoconductor layer comprising photoconductor, binder and additives, which is located on a temporary support, is transferred to the electrically conductive support with the aid of heat and pressure.

2. A process as claimed in claim 1, wherein the temporary support used is a plastic film.

3. A process as claimed in claim 2, wherein the plastic film used is a polyester film.

4. A process as claimed in claims 1 to 3, wherein the organic photoconductor layer is transferred at transfer temperatures in the range from 100 to 180 °C.

5. A process as claimed in claims 1 to 4, wherein the organic photoconductor layer is transferred under a pressure of from 2 to 10 bars.

6. A process as claimed in claims 1 to 5, wherein the electrically conductive support is a metal plate or metal foil.

7. A process as claimed in claim 6, wherein the electrically conductive support is a copper-laminated plastic plate.

8. A process as claimed in claim 6, wherein the electrically conductive support is an aluminum foil with a mechanically roughened surface.

9. A process as claimed in claim 6, wherein the electrically conductive support is an aluminum plate which has been electrochemically roughened, anodically oxydized, and pretreated with polyvinylphosphonic acid or with silicate.

## Revendications

1. Procédé de fabrication de plaques d'impression et de circuits imprimés par revêtement d'un support électriquement conducteur avec une couche de photoconducteur organique et par charge, exposition à la lumière, développement de l'image électrostatique avec un révélateur en fines particules, fixage et élimination de la couche par dissolution aux endroits dépourvus d'image avec un éliminateur de couche ainsi que, le cas échéant, décapage de la surface du support mise à nu, caractérisé en ce que pour le revêtement, on transfère la couche de photoconducteur organique disposée sur un support intermédiaire, constituée d'un photoconducteur, d'un liant et d'additifs, à l'aide de chaleur et de pression, sur le support électriquement conducteur.

2. Procédé suivant la revendication 1, caractérisé en ce qu'on utilise comme support intermédiaire une feuille de matière plastique.

3. Procédé suivant la revendication 2, caractérisé en ce qu'on utilise une feuille de matière plastique en polyester.

4. Procédé suivant l'une quelconque des revendications 1 à 3, caractérisé en ce qu'on transfère la couche de photoconducteur organique à des températures de transfert dans le domaine de 100 à 180 °C.

5. Procédé suivant l'une quelconque des revendications 1 à 4, caractérisé en ce que l'on transfère la couche de photoconducteur organique sous une pression de 2 à 10 bars (2 à $10 \times 10^5$ Pa).

6. Procédé selon l'une quelconque des revendications 1 à 5, caractérisé en ce que le support électriquement conducteur est une plaque ou feuille métallique.

7. Procédé suivant la revendication 6, caractérisé en ce que le support électriquement conducteur est une plaque de matière plastique stratifiée de cuivre.

8. Procédé suivant la revendication 6, caractérisé en ce que le support électriquement conducteur est une feuille d'aluminium dépolie mécaniquement en surface.

9. Procédé suivant la revendication 6, caractérisé en ce que le support électriquement conducteur est une plaque d'aluminium électrochimiquement dépolie, anodisée et prétraitée avec de l'acide polyvinylphosphonique ou avec du silicate.